# EUROPÄISCHE PATENTSCHRIFT

(11) **EP 1 376 236 B1**
(45) Veröffentlichungstag und Bekanntmachung des Hinweises auf die Patenterteilung: **31.05.2006**
(21) Anmeldenummer: 03013746.7
(22) Anmeldetag: 17.06.2003
(51) Int. Cl.: G03F 7/20, G03F 9/00

(54) **Verfahren zum Belichten eines Halbleiterwafers in einem Belichtungsapparat**
Process for exposing a semiconductor wafer in an exposure device
Procédé pour exposer une plaquette de semiconducteur dans un appareil d'exposition

(30) Priorität: 19.06.2002 DE 10227304
(43) Veröffentlichungstag der Anmeldung: 02.01.2004
(73) Patentinhaber: Infineon Technologies AG, 81669 München (DE)
(72) Erfinder: Stäcker, Jens, 01099 Dresden (DE); Hommen, Heiko, 01099 Dresden (DE)
(74) Vertreter: Epping - Hermann - Fischer

(56) Entgegenhaltungen:
- US-A- 5 597 590
- US-A- 5 738 961
- US-A- 5 757 480
- US-A- 5 968 687
- US-B1- 6 190 836

## Beschreibung

Die vorliegende Erfindung betrifft ein Verfahren zum Belichten eines Halbleiterwafers in einem Belichtungsapparat, wobei der Halbleiterwafer wenigstens eine Justiermarke aufweist, welche in einer ersten Schicht auf dem Halbleiterwafer angeordnet ist und von wenigstens einer auf der ersten Schicht angeordneten zweiten Schicht überdeckt ist. Die Erfindung betrifft insbesondere ein Verfahren, bei dem die von der zweiten Schicht überdeckte Justiermarke zur Verbesserung der Qualität des Belichtungsvorgangs freigelegt wird.

Bei der Herstellung von integrierten Schaltungen unterliegen die Prozesse zur Bildung der eine Schaltung aufbauenden Strukturen strengen Anforderungen insbesondere in Bezug auf eine möglichst hohe Genauigkeit von deren Lagepositionen. Durch die sich ständig fortentwickelnde Prozesstechnik und der damit verbundenen Verkleinerung der Strukturgrößen verringern sich auch die Toleranzen in den Justierprozessen insbesondere bei der lithographischen Projektion. Für die nächste Technologiegeneration sind dabei Justiergenauigkeiten von weniger als 35 nm auf den Halbleiterwafern zu erreichen, welche mit der Herstellung auf 300 mm Halbleiterwafern noch enger zu sehen ist.

Die Hersteller der lithographischen Projektionsanlagen beziehungsweise Belichtungsapparate gewährleisten gegenüber ihren Kunden, den Herstellern der integrierten Schaltungen, jedoch lediglich eine anlagentechnische Justiergenauigkeit von derzeit beispielsweise 22 nm. Für prozesstechnische Ungenauigkeiten, welche von dem Hersteller der integrierten Schaltungen zu vertreten sind, bleibt somit ein Toleranzbereich von nur noch 15 nm übrig, innerhalb dessen Lagepositionen reproduzierbar eingehalten werden müssen. Es ist daher ein besonderes Anliegen, Einflüsse auf den Ablauf der Herstellungsprozesse aus dem Vorprozess zu eliminieren.

Vom Anlagenhersteller zu vertretende Einflüsse wie etwa die Stabilität der Anlage, Linsen-Distorsionen sowie Veränderungen etwa der Substrathaltermontierung (englisch: stage) sind hingegen bereits in dem genannten Toleranzbereich von 22 nm enthalten.

Ein Beispiel für prozesstechnisch bedingte Einflüsse stellen in Mitleidenschaft gezogene Justiermarken dar, welche für die Justierung eines Halbleiterwafers in einem lithographischen Belichtungsapparat eingesetzt werden. In einem Lithographieschritt erzeugte Strukturen von Justiermarken werden oftmals in nachfolgenden Abscheide-, Ätz- und/oder Polierschritten mit weiteren Schichten überzogen, wobei deren Profile in Mitleidenschaft gezogen werden.

Die Wiedererkennung durch die Justieroptiken in den Belichtungsapparaten ist dabei oftmals systematischen Fehlern unterworfen. Beispielsweise kann dabei eine Justiermarke durch eine weitere Schicht überdeckt werden, so daß der Strukturkontrast auf nachteilhafte Weise reduziert wird. Ebenso kann ein Polierschritt, welcher anisotrop auf die Oberflächentopographie einwirkt, zu einer asymmetrischen Ausformung der Kantenprofile führen. Dies kann in einer Verschiebung der Justiermarkenposition resultieren. Die nicht stochastische Verteilung der Kantenprofile und die Abscheidungs- bzw. Ätzcharakteristika über die Scheibe verringernden Toleranzbereich von 15nm.

Ein Lösungsvorschlag besteht darin, eine sogenannte Freibelichtung des Halbleiterwafers durchzuführen. Dazu werden speziell für diesen Zweck eingerichtete Masken bereitgestellt, welche ausschließlich entsprechende der Justiermarkenposition auf dem Halbleiterwafer transparente Öffnungen auf einem Glassubstrat aufweisen. In einem Belichtungsapparat, etwa einem Stepper oder Scanner, werden dann genau jene Bereiche eines auf dem Halbleiterwafer aufgebrachten Resists belichtet, welche oberhalb der Justiermarken liegen. In einem selektiven Ätzprozess wird anschließend die Schicht oberhalb der Justiermarken entfernt, so daß die Justiermarken freiliegen. Nach dem Entfernen des Resists wird der Halbleiterwafer mit den freigelegten Justiermarken dem eigentlichen Belichtungsprozess in dem Belichtungsapparat zugeführt.

Eine solche nach herkömmlicher Art und Weise durchgeführte Freibelichtung ist beispielsweise in der Druckschrift US 5,968,687 A beschrieben.

Ein besonderer Nachteil besteht hierbei darin, daß die Durchführung dieser Freibelichtungen die Verfügbarkeit der vergleichsweise teuren Belichtungsapparate für den eigentlichen Strukturierungsprozeß mit Ebenen einer integrierten Schaltung mindert. Ein Durchsatz von nur 100 Wafern pro Stunde für Freibelichtungen rechtfertigt kaum den Einsatz von durchschnittlich etwa 4 Millionen € für ein solches Gerät.

Es ist daher die Aufgabe der vorliegenden Erfindung, ein Verfahren anzubieten, mit dem einerseits die Qualität der Herstellung von integrierten Schaltungen erhöht wird, andererseits aber der Kostenaufwand für die Herstellung reduziert wird.

Die Aufgabe wird gelöst durch ein Verfahren zur Belichtung eines Halbleiterwafers in einem Belichtungsapparat mit den Merkmalen des Anspruchs 1. Vorteilhafte Ausgestaltungen der vorliegenden Erfindung sind den untergeordneten Ansprüchen zu entnehmen.

Der vorliegenden Erfindung zufolge wird die Freibelichtung der Justiermarken nicht mehr in einem lithographischen Projektionsgerät wie einem Scanner oder einem Stepper durchgeführt, sondern es wird zur Durchführung der Belichtung ein Mikroskopmessgerät verwendet. Dieses Mikroskopmessgerät umfasst Lichtquellen sowohl im visuellen als auch im ultravioletten Spektralbereich, zwischen welchen umgeschaltet werden kann.

Während die der Definition der freizubelichtenden Bereiche dienende erste Resistschicht nur in einem der beiden Wellenlängenbereiche photoempfindlich ist, wird der jeweils andere Wellenlängenbereich ausgewählt, um eine Grob- oder Feinjustierung des Halbleiterwafers in dem Mikroskopmessgerät durchführen zu können. Die zweite Lichtquelle, welche vorzugsweise Licht im ultravioletten Wellenlängenbereich ausstrahlt, wird anschließend dazu verwendet, über das optische Linsensystem die Lichtquelle ohne Verwendung einer kostenaufwendigen Maske in die erste Resistschicht auf dem Halbleiterwafer abzubilden. Die erste Resistschicht wird dadurch belichtet. Die Lichtquellen können durch Laserlicht, Halogenlampen oder andere schmal- bzw. breitbandige Lichtquellen realisiert werden. Auch die Einrichtung schmal- oder breitbandiger Spektralfilter etwa auf Weißlichtquellen ist möglich.

Erfindungsgemäß können demnach handelsübliche Inspektionsgeräte für Strukturen auf Halbleiterwafern verwendet werden, welche gerade in zwei verschiedenen Wellenlängenbereichen ausstrahlende Lichtquellen aufweisen. Dabei kann es sich entweder um wenigstens zwei verschiedene Lichtquellen oder um eine Lichtquelle mit wenigstens zwei unterschiedlichen, einschaltbaren Filtern handeln, welche für jeweils unterschiedliche Wellenlängenbereiche lichtdurchlässig sind.

Die in solchen Mikroskopmessgeräten im allgemeinen angebotene Funktion, mittels der Lichtquellen den Halbleiterwafer zu beleuchten, mit einem Detektor das reflektierte Licht aufzufangen und als Bild auszuwerten, ist erfindungsgemäß dabei nur für eine der beiden Lichtquellen vorgesehen, vorzugsweise mit der visuellen Lichtquelle. Die Funktion dient hierbei dazu, eine vorgegebene Justiermarke für das Justieren im Mikroskopmessgerät zu erkennen, deren Position zu messen und mit einer zu der Justiermarke vorgegebenen Position zu vergleichen.

Der erfindungsgemäß aufgebrachte erste Resist wird anschließend bei einer Umschaltung auf den zweiten Wellenlängenbereich belichtet, anstatt daß ein für diesen Wellenlängenbereich erzeugtes Bild mittels einer Detektoreinheit erstellt wird.

Bei dem Mikroskopmessgerät kann es sich um ein Defektinspektionsgerät, einem Gerät zur Messung der Lagegenauigkeit (englisch: overlay tool) oder um ein Gerät zur Bestimmung von Strukturbreiten (critical dimension), etc. handeln. Ein wichtiges Kriterium dabei ist, daß der auf das Substrat geführte Lichtstrahl eine hinreichend kleine Ausdehnung und eine genaue Fokussierung aufweist.

Dies wird beispielsweise erreicht, indem das Licht der Lichtquelle etwa über einen Strahlungsteiler in den Strahlengang des optischen Linsensystems geführt und mit hoher Auflösung auf die Oberfläche des Halbleiterwafers gebracht wird. Die Ausdehnung des Lichtpunktes entspricht dabei der Ausdehnung der Lichtquelle multipliziert mit dem Verkleinerungsfaktor, welcher durch das optische Linsensystem gegeben ist. Typische Werte liegen in dem Bereich zwischen 1 *µ*m und 400 *µ*m. Derzeit verwendete Justiermarken für Stepper beispielsweise der Firma ASML besitzen eine Größe vom 720 x 70 µm, wobei hier gegebenenfalls auch Unterstrukturen aufzulösen sind. Eine andere Justiermarke für Stepper oder Scanner in Form eines Kreuzes besitzt eine Größe von 60 x 60 µm.

Das erfindungsgemäße Verfahren bietet den besonderen Vorteil, daß ein kostengünstiges Mikroskopmessgerät genutzt werden kann, um eine Freibelichtung zu ermöglichen. Somit wird die Gerätekapazität an hochwertigen Belichtungsapparaten erhöht, während durch den hohen Automatisierungsgrad von Mikroskopmessgeräten eine effiziente Freibelichtung beliebiger Justiermarken auch in Hinblick auf die zukünftigen 300 mm Produktionstätten ermöglicht wird. Insbesondere für zukünftige Technologiegenerationen wird daher eine höhere Qualität und ein größerer Toleranzspielraum in bezug auf reproduzierbare Lagegenauigkeiten von Strukturen erreicht.

Die Erfindung soll nun in einem Ausführungsbeispiel anhand einer Zeichnung näher erläutert werden. Darin zeigen:
- Figur 1: in Querschnittsprofilen eine Sequenz von Schritten gemäß dem erfindungsgemäßen Verfahren,
- Figur 2: ein vorteilhaftes Ausführungsbeispiel zur Anordnung von Justiermarken in einem Gitter von Belichtungsfeldern für einen Stepper oder Scanner.

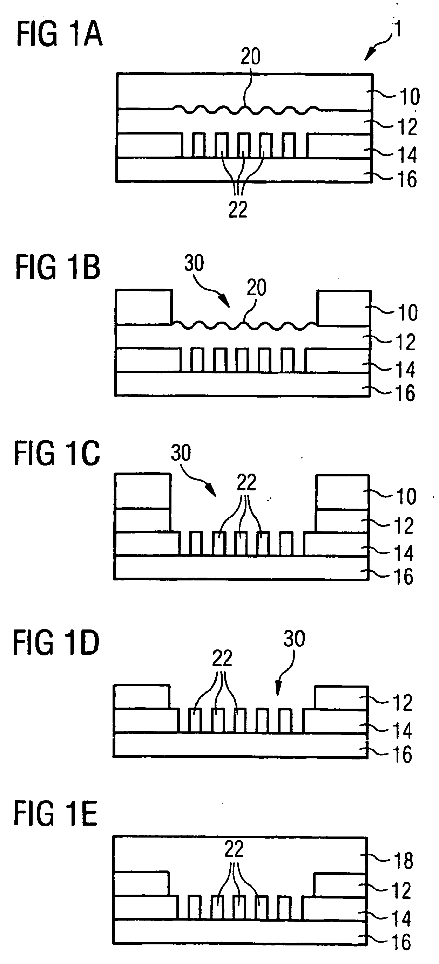

In Figur 1 ist in einer Sequenz von Querschnittsprofilen durch eine Justiermarke 22 auf einem Halbleiterwafer 1 eine Abfolge von Prozessschritten zum Freilegen der Justiermarke 22 für einen Maskenbelichtungsschritt in einem Belichtungsapparat, etwa einem Stepper oder Scanner, dargestellt. Figur 1a zeigt den Zustand zu Beginn der Abfolge der erfindungsgemäßen Prozessschritte. Auf einem Substrat 16 beziehungsweise einer vergrabenen Schicht 16 ist eine Schicht 14 angeordnet, in welcher die Justiermarke 22 gebildet ist. Die Abbildung zeigt dabei einen Querschnitt durch eine aus 6 langen, parallelen Balken bestehende Justiermarke 22. Auf der ersten Schicht 14 ist eine zweite Schicht 12 angeordnet, welche in einem nachfolgenden Abscheideschritt beispielsweise zur Bildung eines Interlayerdielektrikums (ILD) abgeschieden wird.

Die Struktur der Justiermarken 22 in der ersten Schicht 14 spiegelt sich aufgrund der konformen Abscheidung in einer qualitativ schlechteren Abbildung 20 der Strukturen an der Oberfläche der zweiten Schicht 12 wieder. Um die Justiermarke 22 freizulegen, wird daher zunächst eine erste Resistschicht 10 auf der zweiten Schicht 12 abgeschieden. Bei der ersten Resistschicht 10 handelt es sich um einen sogenannten DUV-Resist (Deep-UV), welcher bei einer Wellenlänge von 248 nm photoempfindlich ist.

In einem zweiten Schritt wird der Halbleiterwafer 1 in ein programmierbares Defektdichte-Mikroskop, welches zuvor bereitgestellt wurde, geladen. Es handelt sich hier beispielsweise um ein Gerät vom Typ INS3000 der Firma Leica. In dem Defektdichte-Mikroskopmeßgerät wird zunächst ein sogenanntes Global Alignment (Grobjustierung) des Halbleiterwafers 1 durchgeführt. Dazu kann beispielsweise eine Ecke, Kante oder sonstige kennzeichnende Einkerbung auf dem Halbleiterwafer 1 verwendet werden.

Das Mikroskopmessgerät besitzt einen verfahrbaren Substrathalter (Stage). Der Halbleiterwafer 1 umfaßt einen Satz von Justiermarken, welche für die Justage in dem Defektdichte-Mikroskop geeignet sind. Deren Positionskoordinaten, welche aus den Daten des Produktlayouts stammen, werden in eine Steuersequenz des Mikroskopes eingegeben und nacheinander mittels des Substrathalters angefahren. Eine Detektoreinheit, beispielsweise ein Bildauswertesystem, in dem Mikroskopmessgerät erkennt die gespeicherten Justiermarken aufgrund ihrer Form und vergleicht deren gemessene Positionen mit den vorgegebenen Positionskoordinaten. Nachdem alle Marken angefahren worden sind, wird aus den gemessenen Differenzen zu den Layoutdaten eine Feinjustierung des Halbleiterwafers 1 vorgenommen. Die Erkennung der Justiermarken wird bei visuellem Licht durchgeführt, welches aus einer Halogenlampe stammt.

Da die erste Resistschicht 10 nicht photoempfindlich gegenüber dem visuellen Licht mit einer Frequenz zwischen 430 nm und 700 nm ist, wird die erste Resistschicht 10 nicht belichtet. Andererseits kann die Detektoreinheit anhand des auf dem Substrat reflektierten Lichts die Form der Justiermarken unter der ersten Resistschicht 10 erkennen.

Als nächstes werden in einer zweiten Steuersequenz, welche idealerweise mit der ersten Steuersequenz zusammengefaßt ist; die Positionskoordinaten der erfindungsgemäßen Justiermarken eingegeben. Diese Justiermarken, deren Anzahl beispielsweise bei 5 liegt, können, müssen aber nicht identisch mit den vorgenannten Justiermarken sein, welche lediglich für die Justage in dem Defektdichte-Mikroskop verwendet werden. Deren Anzahl beträgt beispielsweise 20.

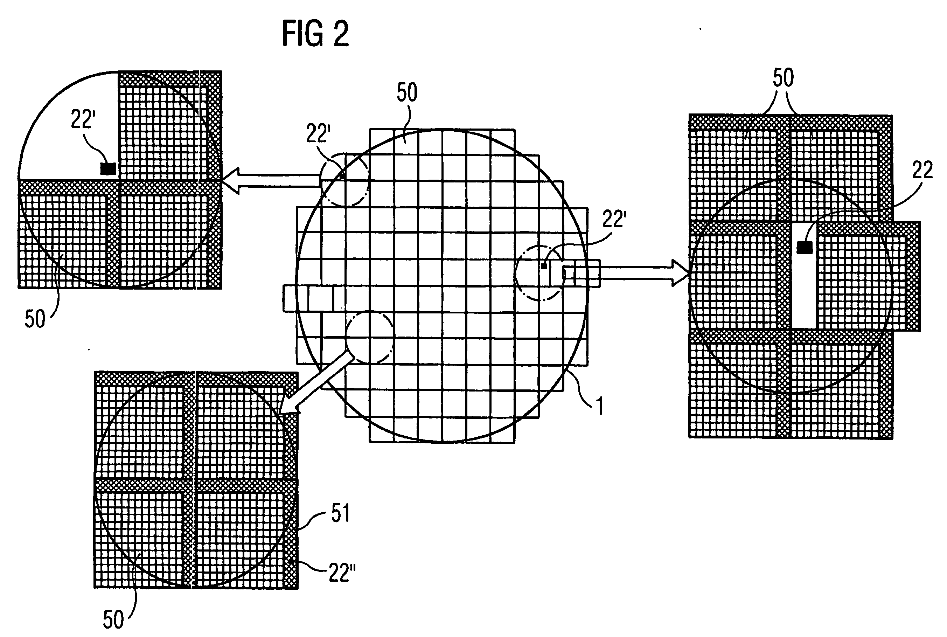

Anhand der Steuersequenz fährt der verfahrbare Substrathalter die 5 Justiermarken in den Strahlengang des optischen Linsensystems des Mikroskopmessgeräts. Ohne daß ein Bild aufgenommen wird, wird nun eine Lichtquelle mit ultraviolettem Licht (Deep UV) von 248 nm für eine Zeitdauer zwischen 3 und 10 Sekunden eingeschaltet. Die Auflösung des Lichtpunktes beträgt 10 µm. Bei den Justiermarken 22 handelt es sich beispielsweise um Marken 22' (siehe auch Fig. 2), welche oftmals für eine Justierung in einem Stepper oder Scanner der Firma ASML mit einer Größe von 640 x 640 *µ*m eingesetzt werden unter der Bezeichnung PM-Marken (primary marks). Über den Justiermarken wird ein Bereich 30 in dem Resist oberhalb der Justiermarken durch den Substrathalter im vorliegenden Ausführungsbeispiel Punkt für Punkt abgerastert, wobei jeder Punkt einen Durchmesser von 10 *µ*m besitzt.

Es ist auch möglich, einen linearen Scan-Vorgang durchzuführen, wobei die Dauer der Belichtung eines Punktes von dem Strahldurchmesser und der Scan-geschwindigkeit abhängt. Die Abrasterung erfolgt gemäß den aus dem Produktlayout stammenden Koordinaten der Justiermarken.

Eine weitere Möglichkeit besteht in der Verwendung von Mikroskop-Tuben mit variabel einstellbaren Vergrößerungen, so daß durch eine einmalige, lineare, kontinuierliche Abrasterung (Scan) die 40 *µ*m breite Justiermarke 22 belichtet werden kann. Es gibt beispielsweise Marken der Firma Canon mit einer Größe von ca. 35 µm x 120 µm. Es reicht demnach ein einziger Scan über diese Justier-marke entlang einer 35 *µ*m breiten Bahn auf dem Substrat.

Eine weitere vorteilhafte Ausführungsform besteht darin, daß zur Freibelichtung einer sog. XY Marke 22, welche 60 x 60 µm groß ist, ein Tubus des Mikroskops mit 65 µm als Durchmesser verwendet wird. Hier kann erfindungsgemäß ein im Mikroskop angebrachtes Shutter einfach nur einmalig geöffnet und geschlossen werden.

Anschließend wird der Halbleiterwafer 1 ausgeladen und in einem Entwickler entwickelt (Figur 1b). Der Bereich 30 oberhalb der Justiermarke 22 wird dabei aus der ersten Resistschicht 10 entfernt.

Die gewünschte Struktur in dem Bereich 30 wird dann in einem Ätzvorgang in die zweite Schicht 12 übertragen. Der Ätzvorgang ätzt die zweite Schicht 12 selektiv gegenüber der ersten Schicht 14. Die Justiermarke 22 wird damit freigelegt (Figur 1c).

Nach der Entfernung des ersten Resists 10 (Figur 1d) wird ein zweiter Resist 18 aufgebracht, welcher bei 193 nm photoempfindlich ist und dem Belichtungsvorgang in einem Belichtungsapparat wie einen Stepper oder Scanner dient (Figur 1e). Der Halbleiterwafer 1 wird nun dem Belichtungsapparat zugeführt und anhand der freigelegten 5 Justiermarken 22 auf einem Substrathalter in dem Belichtungsapparat justiert. Anschließend wird eine Belichtung mit einer Maske in einem lithographischen Projektionsschritt durchgeführt.

Figur 2 zeigt eine vorteilhafte Anordnung von Justiermarken in einer Matrix von Belichtungfeldern auf einem Halbleiterwafer gemäß dem Verfahren der vorliegenden Erfindung. Die Justiermarken 22' liegen in freien Bereichen zwischen den Belichtungsfeldern 50, beispielsweise in Randbereichen des Halbleiterwafers 1, welche jeweils nicht mehr genug Platz zur Belichtung eines kompletten Belichtungsfeldes bieten. Eine vorteilhafte Positionierung der Marken in der Mitte des Wafers wird möglich, wenn Belichtungsfelder 50 reihenweise so weit nach außen verschoben werden, daß gerade eben noch kein Belichtungsfeld 50 durch Verschieben über den Rand verloren geht.

Bei den Justiermarken 22' handelt es sich um 640 *µ*m x 640 *µ*m große PM-Marken der Firma ASML. Fig. 2 zeigt auch Justiermarken 22'' der Firma ASML, welche eine Größe von 720 µm x 70 µm aufweisen (SPM-Marken, scribeline primary marks). Diese weisen somit eine hinreichend geringe Breite auf, so daß sie in den beispielsweise 90 µm breiten Sägerahmen 51 zwischen den Belichtungsfeldern 50 hineinpassen.

Dieses Beispiel stellt den besonderen Vorteil der vorliegenden Erfindung heraus, daß keine explizit hergestellte Freibelichtungsmaske eingesetzt wird, um Freibelichtungen von Justiermarken durchzuführen. Da das Mikroskopmessgerät dynamisch die Positionskoordinaten anfährt und belichtet, kann das vorliegende Verfahren effizient bei Maskensätzen mit häufigen Layoutänderungen auch im Bereich der Justiermarken eingesetzt werden. Es muß nicht bei jeder Änderung des Layouts eine neue Freibelichtungsmaske bestellt werden.

### Bezugszeichenliste:

- 1: Halbleiterwafer
- 10: erste Resistschicht
- 12: Substrat
- 14: erste Schicht
- 16: zweite Schicht
- 18: zweite Resistschicht
- 20: Abbildung der Justiermarke in der zweiten Schicht
- 22: Justiermarke
- 30: belichteter Bereich oberhalb Justiermarke
- 50: Belichtungfeld für Maskenprojektion

## Patentansprüche

1. Verfahren zum Belichten eines Halbleiterwafers (1) in einem Belichtungsapparat, wobei der Halbleiterwafer wenigstens eine Justiermarke (22) aufweist, welche in einer ersten Schicht (14) auf dem Halbleiterwafer (1) angeordnet ist und von wenigstens einer auf der ersten Schicht (14) angeordneten zweiten Schicht (12) überdeckt ist, umfassend die Schritte
- Bereitstellen des Halbleiterwafers (1),
- Aufbringen einer ersten Resistschicht (10) auf die zweite Schicht (12),
- Zuführen des Halbleiterwafers (1) zu einem Mikroskopmessgerät, welches umfasst:
a) ein optisches Linsensystem,
b) eine erste Lichtquelle im visuellen Wellenlängenbereich,
c) eine zweite Lichtquelle im ultravioletten Wellenlängenbereich,
d) einen verfahrbaren Substrathalter,
e) eine Umschaltvorrichtung zum Umschalten von der ersten auf die zweite Lichtquelle,
f) eine Detektoreinheit mit einem Bildauswertesystem,
- Erkennen der Justiermarke (22) anhand der ersten Lichtquelle im visuellen wellenlängenbereich durch das optische Linsensystem und Verfahren der Justiermarke (22) mit Hilfe des Substrathalters in den Strahlengang des optischen Linsensystems,
- Umschalten von der ersten auf die zweite Lichtquelle mittels der Umschaltvorrichtung,
- Belichten der ersten Resistschicht (10) anhand der zweiten Lichtquelle im ultravioletten wellenlängenbereich durch das optische Linsensystem in einem Bereich (30) oberhalb der Justiermarke (22),
- Entwickeln der belichteten ersten Resistschicht (10) zum Öffnen des Bereichs (30) oberhalb der Justiermarke (22),
- Ätzen der zweiten Schicht (12) in dem Bereich (30) oberhalb der Justiermarke (22) zum Freilegen der Justiermarke (22),
- Entfernen der ersten Resistschicht (10),
- Aufbringen einer zweiten Resistschicht (18) auf den Halbleiterwafer (1),
- Justieren des Halbleiterwafers (1) in dem Belichtungsapparat anhand der wenigstens einen Justiermarke (22),
- Belichten der zweiten Resistschicht (18) in dem Belichtungsapparat durch Projektion einer Struktur von einer Maske auf den Halbleiterwafer (1).

2. Verfahren nach Anspruch 1,
**dadurch gekennzeichnet, dass**
das verwendete Mikroskopmessgerät geeignet ist, eine Bestimmung der Dichte von Defekten auf einem Halbleiterwafer (1) vorzunehmen.

3. Verfahren nach Anspruch 1,
**dadurch gekennzeichnet, dass**
die Belichtung der ersten Resistschicht (10) ohne einen Schritt der Projektion einer Maskenstruktur auf den Halbleiterwafer (1) durchgeführt wird.

4. Verfahren nach einem der Ansprüche 1 bis 3,
**dadurch gekennzeichnet, dass**
der durch die Lichtquelle erzeugte Lichtstrahl auf der Oberfläche des Resists eine Ausdehnung von mehr als 1 *µ*m und von weniger als 400 *µ*m besitzt.

5. Verfahren nach einem der Ansprüche 1 bis 3,
**dadurch gekennzeichnet, dass**
die erste Resistschicht (10) gegenüber Licht in einem Wellenlängenbereich zwischen 193 nm und 365 nm fotoempfindlich ist.

## Claims

1. Method of exposing a semiconductor wafer (1) in an exposer, the semiconductor wafer having at least one alignment mark (22) which is arranged in a first layer (14) on the semiconductor wafer (1) and is covered by at least a second layer (12) arranged on the first layer (14), comprising the following steps
- providing the semiconductor wafer (1),
- applying a first resist layer (10) to the second layer (12),
- bringing the semiconductor wafer (1) to a microscope measuring instrument which comprises
a) an optical lens system,
b) a first light source in the visible wavelength range,
c) a second light source in the ultraviolet wavelength range,
d) a movable substrate holder,
e) a changeover device for changing over from the first to the second light source,
f) a detector unit with an image evaluation system,
- detecting the alignment mark (22) by the optical lens system on the basis of the first light source in the visible wavelength range and moving the alignment mark (22) into the beam path of the optical lens system with the aid of the substrate holder,
- changing over from the first light source to the second light source by means of the changeover device
- exposing the first resist layer (10) by means of the optical lens system on the basis of the second light source in the ultraviolet wavelength range, in a region (30) above the alignment mark (22),
- developing the exposed first resist layer (10) in order to open up the region (30) above the alignment mark (22),
- etching the second layer (12) in the region (30) above the alignment mark (22) in order to expose the alignment mark (22),
- removing the first resist layer (10),
- applying a second resist layer (18) to the semiconductor wafer (1),
- aligning the semiconductor wafer (1) in the exposer by using the at least one alignment mark (22),
- exposing the second resist layer (18) in the exposer by projecting a structure from a mask onto the semiconductor wafer (1).

2. Method according to Claim 1, **characterized in that** the microscope measuring instrument used is suitable for performing a determination of the density of defects on a semiconductor wafer (1).

3. Method according to Claim 1, **characterized in that** the exposure of the first resist layer (10) is carried out without a step of projecting a mask structure onto the semiconductor wafer (1).

4. Method according to one of Claims 1 to 3, **characterized in that** the light beam produced by the light source on the surface of the resist has an extent of more than 1 µm and of less than 400 µm.

5. Method according to one of Claims 1 to 3, **characterized in that** the first resist layer (10) is photosensitive to light in a wavelength range between 193 nm and 365 nm.

## Revendications

1. Procédé d'exposition d'une plaquette (1) à semi-conducteurs dans un appareil d'exposition, la plaquette à semi-conducteurs ayant au moins un repère (22) d'alignement qui est disposé dans une première couche (14) sur la plaquette (1) à semi-conducteurs et qui est recouvert d'au moins une deuxième couche (12) disposée sur la première couche (14) comprenant les stades dans lesquels :
- on se procure la plaquette (1) à semi-conducteurs ;
- on dépose une première couche (10) de résist sur la deuxième couche (12) ;
- on apporte la plaquette (1) de semi-conducteurs à un appareil de mesure au microscope, qui comprend :
a) un système de lentille optique ;
b) une première source lumineuse dans le domaine des longueurs d'ondes visibles ;
c) une deuxième source lumineuse dans le domaine des longueurs d'ondes ultraviolettes ;
d) une platine déplaçable ;
e) un dispositif de commutation pour passer de la première à la deuxième source lumineuse ;
f) une unité formant détecteur ayant un système d'exploitation d'images ;
- on détecte le repère (22) d'alignement au moyen de la première source lumineuse dans le domaine des longueurs d'ondes visibles par le système de lentille optique et on déplace le repère (12) d'alignement à l'aide de la platine dans le trajet de rayonnement du système de lentille optique ;
- on passe de la première à la deuxième source lumineuse au moyen du dispositif de commutation ;
- on expose la première couche (10) de résist au moyen de la deuxième source lumineuse dans le domaine des longueurs d'ondes ultraviolettes par le système de lentille optique dans une zone (30) au-dessus du repère (22) d'alignement ;
- on développe la première couche (10) de résist exposée pour ouvrir la zone (30) au-dessus du repère (22) d'alignement ;
- on attaque la deuxième couche (12) dans la zone (30) au-dessus du repère (22) d'alignement pour mettre à nu le repère (22) d'alignement ;
- on élimine la première couche (10) de résist ;
- on dépose une deuxième couche (18) de résist sur la plaquette (1) à semi-conducteurs ;
- on aligne la plaquette (1) à semi-conducteurs dans l'appareil d'exposition au moyen du au moins un repère (22) d'alignement ;
- on expose la deuxième couche (18) de résist dans l'appareil d'exposition par projection d'une structure d'un masque sur la plaquette (1) à semi-conducteurs.

2. Procédé suivant la revendication 1,
**caractérisé en ce que** l'appareil à microscope utilisé est propre à effectuer une détermination de la densité de défauts sur une plaquette (1) de semi-conducteurs.

3. Procédé suivant la revendication 1,
**caractérisé en ce que** l'on effectue l'exposition de la première couche (10) de résist sans un stade de projection d'une structure de masque sur la plaquette (1) à semi-conducteurs.

4. Procédé suivant l'une des revendications 1 à 3,
**caractérisé en ce que** le faisceau lumineux produit par la source lumineuse sur la surface du résist a une étendue de plus de 1 µm et de moins de 400 µm.

5. Procédé suivant l'une des revendications 1 à 3,
**caractérisé en ce que** la première couche (10) de résist est photosensible à de la lumière dans un domaine de longueurs d'ondes compris 193 nm et 365 nm.
